# EUROPEAN PATENT APPLICATION

(11) **EP 4 485 742 A1**
(43) Date of publication of application: **01.01.2025**
(21) Application number: 23182748.6
(22) Date of filing: 30.06.2023
(51) Int. Cl.: H02J 7/00, B60L 3/00, B60L 58/14, B60L 58/15, H02H 7/18, G01R 31/382, H01M 10/48

(54) **BATTERY MANAGEMENT SYSTEM, BATTERY PACK AND SWITCH DEVICE CONTROL METHOD**

(71) Applicant: Munich Electrification GmbH, 81373 Munich (DE)
(72) Inventor: GOEDE, Stefan, 80799 Munich (DE)
(74) Representative: Grünecker Patent- und Rechtsanwälte PartG mbB

(57) **Abstract**

The present disclosure relates to a battery management system, a battery protection system, a battery pack comprising the battery management system, and a switch device control method performed by the battery management system. The battery management system (100, 300) comprises a main battery protection circuitry (104), which is configured to determine a state of a battery (1) as a first determined state, and to generate first control instructions (106) indicating to open or to close at least one switch device (2), which is connected in series with the battery (1), in accordance with the first determined state, and an auxiliary battery protection circuitry (110), separate from the main battery protection circuitry (104), configured to determine the state of the battery (1) as a second determined state, and to generate second control instructions (112) indicating to open or to close the at least one switch device (2) in accordance with the second determined state. A switch device control circuitry (108) is configured to receive the first control instructions (106) from the main battery protection circuitry (104) and the second control instructions (112) from the auxiliary battery protection circuitry (110), and control the at least one switch device (2) to be opened or to be closed in accordance with the received control instructions, wherein the switch device control circuitry (108) is configured to control the at least one switch device (2) to be closed, when at least one of the first control instructions (106) and of the second control instructions (112) indicate to close the at least one switch device (2).

## Description

The present disclosure relates to a battery management system, a battery protection system, a battery pack comprising the battery management system, and a switch device control method performed by the battery management system.

With the advanced development of electric vehicles (EV), in particular battery electric vehicles (BEV), and hybrid electric vehicles (HEV), in particular plug-in hybrid electric vehicles (PHEV), high voltage battery packs become more and more common in vehicles like buses, trucks or passenger cars.

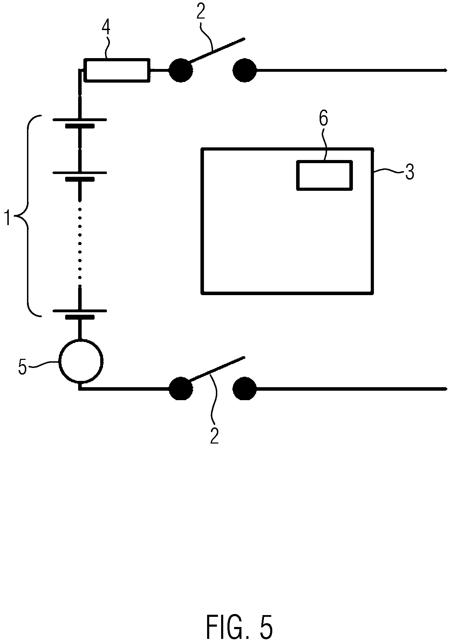

Typically, high voltage battery packs used in electric vehicles comprise 80 to 300 battery cells connected in series and/or in parallel, to be capable of supplying high voltages in a range between 400 V and 1000 V. In future applications, even more battery cells may be used and higher voltages may be supplied by the high voltage battery packs. As illustrated in Fig. 5, a high voltage power supply system, which is powered by a high voltage battery pack, in general require, besides the battery 1, a battery management system (BMS) 3 in order to measure cell voltages, perform cell balancing, and monitor the cell temperature for improving the available capacity of the battery 1 and increase the individual longevity of each battery cell of the battery 1.

In addition, in order to connect and disconnect the battery 1 on the positive terminal and on the negative terminal to a DC bus that connects the battery to external loads (or to a charger), disconnection switch devices 2, which are controlled by the BMS 3, are electrically connected in series with the terminals of the battery 1. Conventional disconnection switch devices 2 are usually realized by electromechanical contactors, relays or solid state switches, that are capable of reversibly changing their state between a closed state, where current flow through the disconnection switch device 2 device is possible and an open state, where current flow through the disconnection switch device 2 is interrupted, generally by reversibly moving at least one moveable contact.

Further, the HV power supply system usually comprises at least one additional overcurrent protection device 4, which is supervised and activated or triggered by the BMS 3 to immediately and permanently interrupt the current flow in case of an unusual overcurrent, malfunctions of the BMS 3 or because of an accident (crash) of the electric vehicle. Examples for such an overcurrent protection device 4 are fuses, which use a metal wire or a strip that melts, when overcurrent occurs, or in particular pyroelectric devices, also known as pyrofuses, which are activated by triggering a pyroelectric charge for severing a busbar.

In order to enable the BMS 3 to measure a battery current (charging or discharging current) provided by the battery 1 or charging the battery 1, at least one current sensor 5, often in form of a dedicated shunt resistor, is electrically connected in series with the HV battery 1 and the BMS 3 measures the battery current by measuring the voltage applied across the at least one current sensor 5. Thereby, the current sensor 5 can be an internal or external component of the BMS 3.

The BMS 3 comprises a main controller 6 (or BMS main controller 6), usually in form of a microcontroller, which by a combination of software and hardware performs the above mentioned functions. A proper operation of the main controller 6 is indispensable for the protection of the battery 1 in the BMS 3, because otherwise the BMS 3 cannot determine the state of the battery anymore. Hence, the occurrence of a single point fault in the main controller 6 necessarily leads to a disablement of the main controller 6, even if multiple redundant cores are available in the main controller 6. In order to avoid overcharging or over-discharging of the battery 1, to avoid damaging or inflaming the battery 1, the disablement of the main controller 6 triggers a disconnection of the battery 1 by bringing the disconnection switch devices 2 in the open state and/or by activating or triggering the overcurrent protection device 4. Accordingly, the loss of the main controller 6 brings the battery 1 in a safe state, but this necessary safety operation results at the same time in sudden power loss of the battery pack or HV power supply system as soon as a single point fault in the main controller 6 occurs.

In this respect, the inventors of the present invention have found that for applications like autonomous driving or other products with critical availability requirements, such as power grid stabilization, it would be beneficial to avoid a sudden power loss at least for a limited amount of time after a hardware fault in a main controller of a battery management system has occurred. This could enable, for example, to provide a safe stop of the system or to move an electrical vehicle powered by the battery 1 out of a dangerous environment.

Accordingly, it is an object of the present invention to provide a battery management system for a battery, a battery pack comprising the battery management system and a switch device control method, which can overcome the above described disadvantages and can avoid a sudden power loss in case of a random hardware fault in the battery management system and in particular in the control circuitry of the battery management system. Furthermore, it is an object of the present invention to provide a compact and economic solution.

At least one of these objects is solved by the present invention as defined in the independent claims.

In particular, a battery management system according to a first aspect comprises a main battery protection circuitry, which is configured to determine a state of a battery as a first determined state, and to generate first control instructions indicating to open or to close at least one switch device, which is connected in series with the battery, in accordance with the first determined state, and an auxiliary battery protection circuitry, separate from the main battery protection circuitry, configured to determine the state of the battery as a second determined state, and to generate second control instructions indicating to open or to close the at least one switch device in accordance with the second determined state. A switch device control circuitry is configured to receive the first control instructions from the main battery protection circuitry and the second control instructions from the auxiliary battery protection circuitry, and control the at least one switch device to be opened or to be closed in accordance with the received control instructions, wherein the switch device control circuitry is configured to control the at least one switch device to be closed, when at least one of the first control instructions and of the second control instructions indicate to close the at least one switch device.

In this manner, the auxiliary battery protection circuitry is provided as a backup control circuit, which can overtake the determination of the state of the battery and the controlling the at least one switch device after a malfunction of the main battery protection circuit has occurred. This has the advantage, that it is not necessary to disconnect the battery after a malfunction of the main battery protection circuitry has occurred, so that a random hardware fault in the battery management system does not result in the need for suddenly disconnecting the battery. In particular, the battery management system is configured to be able to provide power supply from the battery even after a malfunction of the main battery protection circuit or main controller of the BMS.

According to a second aspect, when a malfunction of the main battery protection circuitry is detected, the main battery protection circuitry is configured to stop operation and to indicate to the switch device control circuitry to open the at least one switch device, and/or when a malfunction of the auxiliary battery protection circuitry is detected, the auxiliary battery protection circuitry is configured to stop operation and to indicate to the switch device control circuitry to open the at least one switch device. In other words, the switch device control circuitry receives from a failed battery protection circuit instructions to open the at least one switch device, so that the switch device control circuitry will immediately open the at least one switch device, as soon as the remaining non-defective battery protection circuitry also indicates to do so. Each of the main battery protection circuitry or the auxiliary battery protection circuitry may, for example, indicate its malfunction with a dedicated control signal to the switch device control circuitry or simply by stop of transmitting the first or second control instructions.

In order to provide an energy-efficient system, according to a third aspect the auxiliary battery protection circuitry only performs the determination of the second determined state and the generation of the second control information after the main battery protection circuit has stopped operation. In other words, the auxiliary battery protection circuitry functions as a backup control circuitry and the battery is only monitored by the main battery protection circuitry as long as the main battery protection circuitry operates.

According to a fourth aspect, the main battery protection circuitry comprises a first voltage converter, which is configured to supply the electric components of the main battery protection circuit, and the auxiliary battery protection circuitry comprises a second voltage converter, which is arranged independently from the first voltage converter and is configured to supply the electric components of the auxiliary battery protection circuit, and the first voltage converter and the second voltage converter are respectively supplied by individual voltage sources. In this manner, the loss of one of the voltage sources or a malfunction in one of the voltage converters does not lead to a complete loss of power supply for the battery management system, so that one of the battery protection circuits can still monitor the operation of the battery and control the at least one switch.

In order to enhance the independency of the state determination performed by the main battery protection circuitry and by the auxiliary battery protection circuitry, according to a fifth aspect the main battery protection circuitry comprises a first measuring circuit for measuring a battery current of the battery, and the auxiliary battery protection circuitry comprises a second measuring circuit for measuring the battery current of the battery.

According to a sixth aspect, the main battery protection circuitry determines a state of charge of the battery by integrating the battery current, when a voltage measurement of the voltage of the battery is not available for the main battery protection circuitry, and/or the auxiliary battery protection circuitry determines the state of charge of the battery by integrating the battery current, when a voltage measurement of the voltage of the battery is not available for the auxiliary battery protection circuitry. In this manner, it is prevented that the BMS needs to open the at least one switch, as soon as the voltage measurement of measuring the battery voltage is not available anymore, because the state of charge of the battery can be determined by current integration.

According to a seventh aspect, the main battery protection circuitry is further configured to control activation of at least one overcurrent protection device, which is connected in series with the battery, in accordance with the state of the battery determined by the main battery protection circuitry and/or in accordance with an external control signal, and the auxiliary battery protection circuitry is further configured to redundantly control activation of the at least one overcurrent protection device in accordance with the state of the battery determined by the auxiliary battery protection circuitry and/or in accordance with the external control signal. This allows for using the auxiliary battery protection circuitry as a backup control circuit for a battery pack, which is used to power an electric vehicle, since the auxiliary battery protection circuitry is able to activate an overcurrent device like a pyrofuse independently from the main battery protection circuitry, and in particular after a loss of operation of the main battery protection circuitry.

In order to further reduce the risk of common hardware faults, according to an eight aspect the main battery protection circuitry and the auxiliary battery protection circuitry are provided on discrete semiconductor chips.

At the same time, in order to simplify the integration with the remaining components of the battery management system, according to a ninth aspect the main battery protection circuitry and the auxiliary battery protection circuitry are housed in a common housing to form a single integrated circuit component.

According to a tenth aspect the switch device control circuitry comprises a first switch device driver, which is configured to open and close the at least one switch device in accordance with the first control instructions received from the main battery protection circuitry, and a second switch device driver, which is configured to open and close the at least one switch device in accordance with the second control instructions received from the auxiliary battery protection circuitry, wherein the first switch device driver and the second switch device driver are configured in such a manner that the at least one switch device is closed, when at least one of the first switch device driver and the second switch device driver closes the at least one switch device. For example, each of the first switch device driver and the second switch device driver may comprise a voltage supply, which function as parallel voltage supplies for the at least one switch, so that the stopping of voltage supply by one of the switch device driver, e.g. in response to a malfunction of one of the battery protection circuits, does not lead to an opening of the at least one switch, because the at least one switch is still energized by the other power supply.

In order to further reduce the risk of common hardware faults, according to an eleventh aspect, the first switch device driver and the second switch device driver are mounted on different discrete integrated circuit components.

According to a twelfth aspect the first switch device driver is configured to open the at least one switch device, when the first switch device driver does not receive a communication signal from the main battery protection circuitry for a first predetermined time, and/or the second switch device driver is configured to open the at least one switch device, when the second switch device driver does not receive a communication signal from the auxiliary battery protection circuitry for a second predetermined time. In this manner, it is automatically indicated to the respective switch driver to open the at least one switch device, if one of the battery protection circuits has a malfunction, so that the state of the at least one switch can be determined independently by the non-defective battery protection circuit.

According to a thirteenth aspect, there is provided a battery protection system, which comprises the battery management system according to one of the first to twelfth aspect, and monitoring circuitry, which is configured to detect presence or absence of a malfunction of the main battery protection circuitry, and when a malfunction of the main battery protection circuitry is detected, output a first notification signal and/or cause the battery to be used with reduced functionality. Hereby the monitoring circuitry may be external to the BMS, e.g. be a functional part of a vehicle ECU, or may be an internal circuitry of the BMS. The reduction of the functionality of the battery may for example include reducing the maximum output power of the battery, limiting the operating range or operating time of the battery, or preventing another start of the battery after the disconnection switches have been opened. Similar, the notification signal may inform a user of the malfunction, for example by causing lighting of a warning light in response to the output of the notification signal.

According to a fourteenth aspect, there is provided a battery pack, which comprises a battery, and the battery management system according to one of the first to twelfth aspect or the battery protection system according to the thirteenth aspect.

According to a fifteenth aspect, there is provided a switch device control method comprising the steps of receiving first control instructions indicating to open or to close at least one switch device, which is connected in series with a battery, wherein the first control instructions are generated by a main battery protection circuit in accordance with a first determined state of the battery, receiving second control instructions indicating to open or to close the at least one switch device, wherein the second control instructions are generated by an auxiliary battery protection circuitry, separate from the main battery protection circuitry, in accordance with a second determined state of the battery, opening and closing the at least one switch device in accordance with the received first control instructions and the received second control instructions, wherein the at least one switch device is closed, when at least one of the first control instructions and of the second control instructions indicate to close the at least one switch device. This method enables a battery management system to achieve the above discussed advantages.

Throughout this document, the terms "cell" or "battery cell" may refer to either a physical battery cell, or several physical battery cells electrically connected in parallel on a cell level.

The accompanying drawings are incorporated into the specification and form a part of the specification to illustrate several examples of the present disclosure. These drawings, together with the description serve to explain the principles of the disclosure. The drawings are merely for the purpose of illustrating the preferred and alternative examples of how the disclosure can be made and used, and are not to be construed as limiting the disclosure to only the illustrated and described examples. Furthermore, several aspects of the examples may form-individually or in different combinations-solutions according to the present disclosure. The following described examples thus can be considered either alone or in an arbitrary combination thereof. Further features and advantages will become apparent from the following more particular description of the various examples of the disclosure, as illustrated in the accompanying drawings, in which like references refer to like elements, and wherein:
- **FIG. 1**: shows a schematic block diagram of a first exemplary battery management system;
- **FIG. 2**: shows a schematic flow chart of a method performed by the exemplary battery management system;
- **FIG. 3**: shows a schematic circuit diagram of a second exemplary battery management system;
- **FIG. 4**: shows a schematic block diagram of an exemplary main control circuitry;
- **FIG. 5**: shows a schematic block diagram of a common battery management system;
- **FIG. 6**: shows another schematic block diagram of the common battery management system.

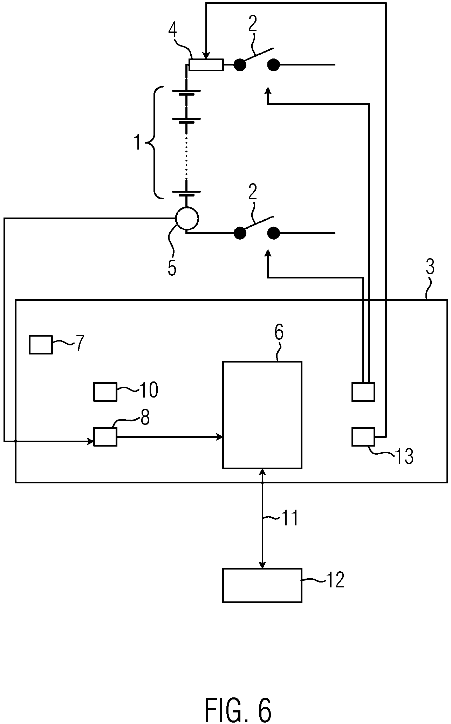

The present disclosure will now be further explained referring to the Figures. Before explaining the aspects of the present disclosure in detail, first the operation and components of the common battery management system 3 will be explained with reference to Fig. 6.

In addition to the BMS main controller 6, which has been described with reference to Fig. 5 in the background section, the BMS 3 also comprises a power supply unit 7, a current sense unit 8, a disconnection switch device driver unit 9, a cell monitoring circuit 10, a communication interface 11 and an overcurrent protection device driver unit 13. The power supply unit 7 supplies the BMS 3 with power and in addition includes one or more supervision circuits, which detect a correct functioning of the BMS main controller 6. The current sense unit 8 comprises one or more analog-to-digital converters (ADCs) for converting an analog voltage output, which corresponds to a voltage applied across the current sensor 5, into a digital battery current measurement signal as an input for the BMS main controller 6. Furthermore, the current sense unit 8 has a function of detecting an overcurrent of the battery 1 and inform the BMS main controller 6. The disconnection switch device driver unit 9 supplies current or power to the actuators of the disconnection switch devices 2 in order to open and close the disconnection switch devices 2 in response to control instructions received by the BMS main controller 6.

The cell monitoring unit 10 typically comprises one or more specific integrated circuits for measuring the voltage and the temperature of the individual battery cells of the battery 1 and of the battery 1 as a whole, so called "cell-monitoring ICs". Each of the cell-monitoring ICs has at least one measurement circuit or ADC for measuring a voltage of at least one battery cell (typically of 6 to 25 battery cells) of the battery for allowing the BMS main controller 6 to determine the voltages of the individual cells of the battery and the voltage indicating the state of charge (SOC) of the battery. In addition, the cell monitoring unit 10 has balancing circuits, for example in form of semiconductor switches, which are actuated by the BMS main controller 6 in order to balance the voltages of the battery cells of the battery 1. The overcurrent protection device driver unit 13 is for example a driver unit for a pyro fuse, which includes circuitry for igniting/actuating a pyroelectric squib of a pyro fuse as the overcurrent protection device 4, in response to an instruction signal received by the BMS main controller 6. The communication interface 11, which may be internal or external to the BMS main controller 6, is provided for allowing the BMS main controller 6 to communicate with an external controller 12, which supervises the operation of the BMS 3 and of the battery 1. For example, the external controller 12 is an electronic control unit of a vehicle (vehicle-ECU) or a superordinate controller of a power grid. The external controller 12 can, for example, control a maximum available power provided by the battery 1 and inform a user of the battery 1, like a vehicle driver, of the status of the battery, and in particular notify or warn the user in case of a malfunction of the battery 1 or the BMS 3.

These electronic components allow the BMS 3 to perform at least the following functions:
- determine the cell voltages of the battery cells of the battery 1, measure the cell temperatures of the battery cells of the battery 1, and perform balancing of the cell voltages;
- determine the battery current of the battery 1;
- read values of analog sensors, which measure, for example, temperatures of a coolant, one or more bus bars, or other components provided in the battery pack, and/or which measure other parameter, such as a humidity, a pressure, a gas concentration or a fluid level within the battery 1 or within individual battery cells;

- control connection and disconnection of the battery 1 by controlling opening and closing of the disconnection switches 2;
- actuate or trigger the overcurrent protection device 4;
- communicate with the external controller 12; and
- evaluate crash or emergency stop signals to determine a crash or emergency stop condition.

Since most of these functions are indispensable for a safe control of the operation of the battery 1, in particular for avoiding an overcharging and over-discharging of the battery 1, it is necessary to bring the battery 1 in a safe state, when the BMS main controller 6 fails, for example due to a hardware fault. This safe state is achieved by controlling the disconnection switch device driver unit 9 to open the disconnection switches 2, as soon as the BMS main controller 6 cannot be guaranteed anymore. However, opening of the disconnection switches 2 leads to a sudden power loss of the power supply by the battery 1, so that it is not possible anymore to further use the power of the battery 1, for example to provide a safe stop of a system powered by the battery 1 or to move an electrical vehicle powered by the battery 1 out of a dangerous environment.

For this reason, the present disclosure provides in the following exemplary battery management systems for the battery 1 which provide high redundancy in performing the above battery management system functions and consequently can avoid a sudden power loss in case of a random hardware fault in a main control circuitry of the exemplary battery management systems.

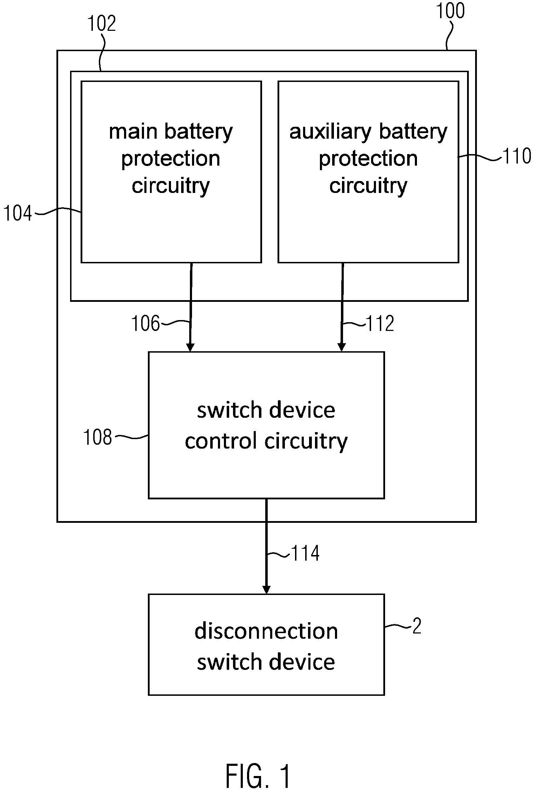

A basic configuration of the exemplary battery management system according to the present disclosure will now be explained by referring to Fig. 1. Fig. 1 shows a schematic block diagram of a first exemplary battery management system 100. The BMS 100 comprises main control circuitry 102, which is configured to monitor and control operation of a (HV) battery 1 (not shown in Fig. 1). For this purpose, the main control circuitry has a main battery protection circuity 104, which is configured to determine a state of the battery 1 as a first determined state of the battery. In particular, the main battery protection circuity 104 at least processes analogue or digital values of the voltage of the battery 1 and a voltage applied across a current sensor, connected in series with the battery 1, in order to determine a state of charge and the battery current of the battery 1. In this manner, the main battery protection circuity 104 can judge that the voltage and the battery current of the battery 1 are in a safe operation region, where operation of the battery is safe without risking overcharging or over-discharging of the battery 1 or a battery overcurrent. On the other hand, the main battery protection circuitry 104 can also determine that the voltage of the battery 1 is in a critical region, e.g. the voltage of the battery 1 is smaller than an over-discharging limit value, so that there is a risk of over-discharging the battery 1, the voltage of the battery 1 is larger than a overcharging limit value, so that there is a risk of overcharging the battery 1, determine that the battery current is larger than an overcurrent limit value when there is an overcurrent, and/or determine that a temperature of at least one of the battery cells of the battery 1 or of the battery 1 as a whole is critical.

Based on the state of the battery 1 determined by the main battery protection circuity 104, i.e. the first determined state of the battery 1, the main battery protection circuitry 104 generates first control instructions 106 and transmits the first control instructions 106 to the switch device control circuitry 108. The switch device control circuitry 108 supplies current or power (indicated by the arrow 114) to the disconnection switch devices 2 (or to at least one switch device) to open or close the disconnection switch devices 2 (or the at least one switch device) depending on the first control instructions 106 received by the main control circuitry 102.

The first control instructions 106 are electric signals, like PWM modulated signals or steady signals, which indicate to the switch device control circuitry 108, whether to open or close the disconnection switch devices 2 ("switch devices"). Hereby, the main battery protection circuitry 104 may, for example, generate continuous or periodic electric signals as the first control instructions 106 when the main battery protection circuitry 104 determines that the disconnection switch devices 2 are to be closed. In this case, the switch device control circuitry 108 supplies current or power to the disconnection switch devices 2 as long as the electric signals are present. Of course, it is alternatively also possible to generate continuous or periodic electric signals, which indicate to open the disconnection switch devices 2, as part of the first control instructions 106. In an alternative implementation, the first control instructions 106 may be dedicated discrete signals, and the switch device control circuitry 108 may only change a state of the disconnection switch devices 2 after receiving a dedicated discrete signal to do so as the first control instruction 106.

Accordingly by the generation of the first control instructions 106, the main battery protection circuitry 104 is able to regulate the power output from the battery 1 and the power input to the battery 1 by controlling the disconnection switch devices 2 via the switch device control circuitry 108. In particular, the main battery protection circuitry 104 can interrupt the power output or the power input of the battery 1, when the main battery protection circuitry 104 determines the battery 1 to be in an unsafe operation condition by instructing the switch device control circuitry 108 to open the disconnection switch devices 2.

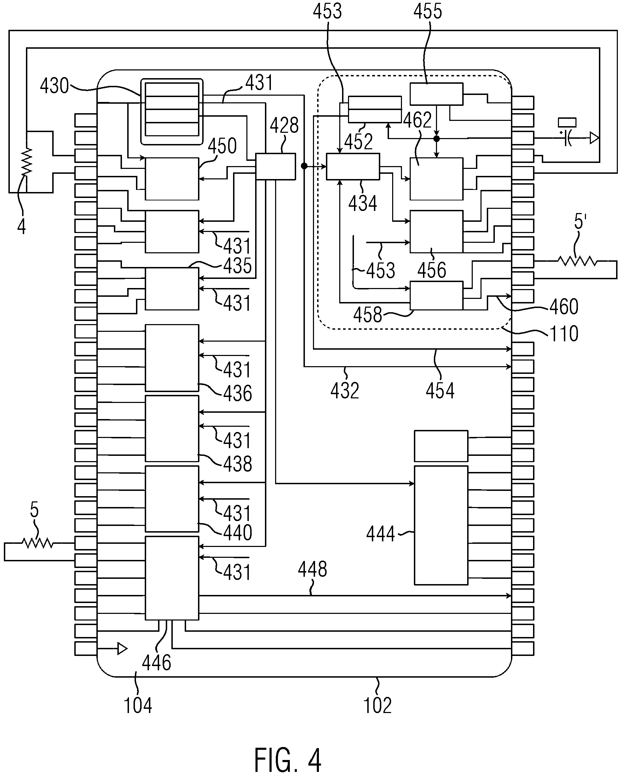

In case that a malfunction of the main battery protection circuitry 104 is determined to occur, either by an internal supervision circuit of the main battery protection circuitry 104 or by an external supervision circuit, which supervises the operation of the main battery protection circuitry 104, the main battery protection circuitry 104 is configured to stop operation. Since in such a case the main battery protection circuitry 104 is not able anymore to reliably determine the state of the battery 1, the main battery protection circuitry 104 in addition is configured to indicate to the switch device control circuitry 108 to open the disconnection switch devices 2. For example by stopping communication with the switch device control circuitry 108, or by outputting a dedicated timeout signal, like it will be explained later with reference to Fig. 4. In particular, the switch device control circuitry 108 is configured to automatically interpret the non-reception (or missing) of first control instructions or another communication signal for a predetermined time as a command to open the disconnection switch devices 2.

In order to prevent that a malfunction of the main battery protection circuitry 104 leads to a sudden power loss of the power supply by the battery 1, the main control circuitry 102 further comprises auxiliary battery protection circuitry 110, which is arranged separately from the main battery protection circuitry 104 to function as a backup circuit for the main battery protection circuitry 104. The auxiliary battery protection circuitry 110 is configured to determine the state of the battery 1 as a second determined state of the battery independently from the determination made by the main battery protection circuitry 104. In particular, the auxiliary battery protection circuitry 110 at least processes analogue or digital values of the voltage of the battery 1 and a voltage applied across a current sensor, connected in series with the battery 1, in order to determine a state of charge and the battery current of the battery 1 independently from the main battery protection circuitry 104.

In this manner, the auxiliary battery protection circuitry 110 can independently (from the main battery protection circuitry 104) judge that the voltage and the battery current of the battery 1 are in a safe operation region, where operation of the battery is safe without risking overcharging or over-discharging of the battery 1 or a battery overcurrent. On the other hand, the auxiliary battery protection circuitry 110 can also separately determine that the voltage of the battery is in a critical region, e.g. smaller than an over-discharging limit value or larger than a overcharging limit value, determine that the battery current is larger than an overcurrent limit value when there is an overcurrent, and/or determine that a temperature of at least one of the battery cells of the battery 1 or the battery 1 as a whole is critical.

Based on the state of the battery 1 determined by the auxiliary battery protection circuity 110, i.e. the second determined state of the battery 1, the auxiliary battery protection circuity 110 generates second control instructions 112 and transmits the second control instructions 112 to the switch device control circuitry 108. In response to receiving the second control instructions 112, the switch device control circuitry 108 supplies current or power (indicated by the arrow 114) to the disconnection switch devices 2 to open or close the disconnection switch devices 2 depending on the second control instructions 112.

The second control instructions 112 may have the same form as described before for the first control instructions 106, but are generated by the auxiliary battery protection circuity 110 independent from the main battery protection circuitry 104. In particular, the second control instructions 112 may be electric signals, like PWM modulated signals or steady signals, which indicate to the switch device control circuitry 108, whether to open or close the disconnection switch devices 2. Hereby, the auxiliary battery protection circuity 110 may, for example, generate continuous or periodic electric signals as the second control instructions 112 when the auxiliary battery protection circuity 110 determines that the disconnection switch devices 2 are to be closed. In this case, the switch device control circuitry 108 supplies current or power to the disconnection switch devices 2 as long as the electric signals are present. Of course, it is alternatively also possible to generate continuous or periodic electric signals, which indicate to open the disconnection switch devices 2, as part of the second control instructions 112. In an alternative implementation, the second control instructions 112 may be dedicated discrete signals, and the switch device control circuitry 108 may only change a state of the disconnection switch devices 2 after receiving a dedicated discrete electric signal to do so as a second control instruction 112.

Accordingly, even in case of a malfunction of the main battery protection circuitry 104, the auxiliary battery protection circuitry 110 is able to regulate the power output from the battery 1 and the power input to the battery 1 by controlling the disconnection switch devices 2 via the switch device control circuitry 108 independent from the main battery protection circuitry 104. In particular, even in case of a malfunction of the main battery protection circuitry 104, the auxiliary battery protection circuitry 110 is still able to interrupt the power output and the power input, when the auxiliary battery protection circuitry 110 determines the battery 1 to be in an unsafe operation condition by instructing the switch device control circuitry 108 to open the disconnection switch devices 2. Hence, it is not necessary to instantaneously interrupt the power supply from the battery 1 in the BMS 100, even when the main battery protection circuitry 104 has a malfunction, since the auxiliary battery protection circuitry 110 operates as a backup control circuitry or redundant control circuitry and still reliably monitors the operation of the battery 1 to be in a safe operation condition.

For this reason, the switch device control circuitry 108 is configured in such a manner that the disconnection switch devices 2 are closed, in each time period, where at least one of the first control instructions 106 and of the second control instructions 112 indicate to close the disconnection switch devices 2. Accordingly, even if the main battery protection circuitry 104 has stopped operation due to a hardware fault or other fault and the first control instructions 106 indicate to open the disconnection switch devices 2, the auxiliary battery protection circuitry 110 can control the disconnection switch devices 2 to be closed or opened by generating corresponding second control instructions 112. Similar, in time periods where the main battery protection circuitry 104 monitors the battery 1 without support from the auxiliary battery protection circuitry 110, the main battery protection circuitry 104 can control the disconnection switch devices 2 to be closed or opened by generating corresponding first control instructions 106.

In order to reduce the power consumption of the BMS 100, the auxiliary battery protection circuitry 110 can operated as a backup for the main battery protection circuitry 104, which is only active when the operation of the main battery protection circuitry 104 has been stopped as outlined above. Alternatively, it is also possible that the auxiliary battery protection circuitry 110 is operated simultaneously with the main battery protection circuitry 104 as a redundant system in order to improve the reliability in the determination of the state of the battery 1. In this case, if a malfunction of the auxiliary battery protection circuitry 110 is determined to occur, either by an internal supervision circuit of the auxiliary battery protection circuitry 110 or by an external supervision circuit, which supervises the operation of the auxiliary battery protection circuitry 110, the auxiliary battery protection circuitry 110 is configured to stop operation. Since in such a case the auxiliary battery protection circuitry 110 is not able anymore to reliably determine the state of the battery 1, the auxiliary battery protection circuitry 110 in addition to indicate to the switch device control circuitry 108 to open the disconnection switch devices 2, for example by stopping communication with the switch device control circuitry 108 or by outputting a dedicated timeout signal, like it will be explained later with reference to Fig. 4. In this manner, an additional malfunction of the main battery protection circuitry 104 will lead to an instantaneous opening of the disconnection switch devices 2 in order to bring the battery 1 in the safe state, which is necessary when both redundant battery protection circuits of the main control circuitry 102 do not operate.

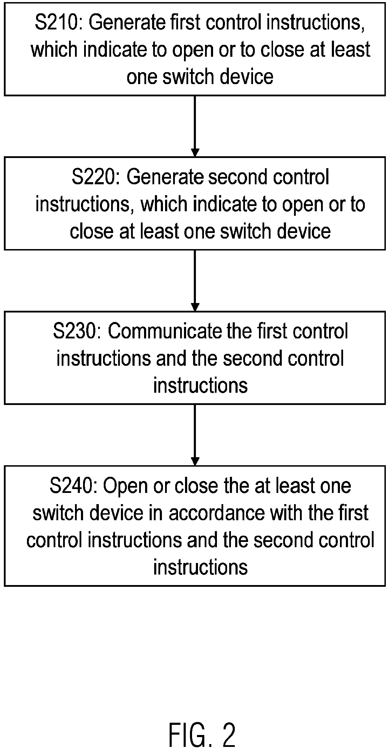

Fig. 2 shows a schematic flow chart of a control method performed by the exemplary battery management system 100. In a first step S210, the main battery protection circuitry 104 generates first control instructions 106, which indicate to open or to close the disconnection switch devices 2. As described before, when the main battery protection circuitry 104 operates regularly, the first control instructions 106 are generated in accordance with the state of the battery 1, which is determined by the main battery protection circuitry 104 as the first determined state of the battery 1. In case that the main battery protection circuitry 104 does not operate, either the missing of the first control instructions 106 or a dedicated electronic signal is received by the switch device control circuitry 108 from the main battery protection circuitry 104 as first control instructions 106, which indicate to open the disconnection switch devices 2.

In a second step S220, the auxiliary battery protection circuitry 110 generates second control instructions 112, which indicate to open or to close the disconnection switch devices 2. As described before, the auxiliary battery protection circuitry 110 acts as a backup circuitry or redundant circuitry for the main battery protection circuitry 104, and generates the second control instructions 112 independently from the main battery protection circuitry 104. In particular, the second control instructions 112 are generated in accordance with the state of the battery 1, which is determined by the auxiliary battery protection circuitry 110 as the second determined state of the battery 1. In case that the auxiliary battery protection circuitry 110 does not operate, for example before a malfunction has stopped operation of the main battery protection circuitry 104, either a missing of the second control instructions 112 or a dedicated electronic control signal is received by the switch device control circuitry 108 from the auxiliary battery protection circuitry 110 as the second control instructions 112, which indicate to open the disconnection switch devices 2.

In a third step S230 the main battery protection circuitry 104 and the auxiliary battery protection circuitry 110 respectively communicate the first control instructions 106 and the second control instructions 112 to the switch device control circuitry 108, so that the switch device control circuitry 108 receives the first control instructions 106 and the second control instructions 112. As outlined before, the control instructions can be communicated by continuous or intermittent electronic signals, like a PWM modulated signal, or can be communicated by not transmitting an electronic signal for a specific time. When the switch device control circuitry 108 does not receive an electronic signal from the main battery protection circuitry 104 for a predetermined time, the switch device control circuitry 108 interprets the missing of the electronic signal as first control instructions 106 to open the disconnection switch devices 2. Similar, when the switch device control circuitry 108 does not receive an electronic signal from the auxiliary battery protection circuitry 110 for a predetermined time, the switch device control circuitry 108 interprets the missing of the electronic signal as second control instructions 112 to open the disconnection switch devices 2.

In a fourth step S240, the switch device control circuitry 108 controls the disconnection switch devices 2 to be open or closed in accordance with the received first control instructions 106 and the second control instructions 112. Here, the switch device control circuitry 108 is designed in such a manner, that a control instruction to close the switch device overrides (or cancels) a control instruction to open the switch device, so that for a continuous time period where at least one of the first control instructions and of the second control instructions indicate to close the disconnection switch devices 2, the disconnection switch devices 2 are closed. This means especially that the switch device control circuitry 108 closes the disconnection switch devices 2 in each time period, for which it receives the first control instructions 106, which indicate to close the disconnection switch devices 2, also when it does not receive the second control instructions 112 for the same time period or even when it receives the second control instructions 112, which indicate to open the disconnection switch devices 2 for the same time period. Similar, the switch device control circuitry 108 closes the disconnection switch devices 2 in each time period, for which it receives the second control instructions 112, which indicate to close the disconnection switch devices 2, also when it does not receive the first control instructions 106 for the same time period or even when it receives the first control instructions 106, which indicate to open the disconnection switch devices 2 for the same time period. This allows to prevent a forceful opening of the disconnection switch devices 2 for the case that still one of the main battery protection circuitry 104 and the auxiliary battery protection circuitry 110 properly monitors the state of the battery 1 even if the other one of the battery protection circuits has a malfunction. Accordingly, a sudden loss of the power supply by the battery 1 can be suppressed.

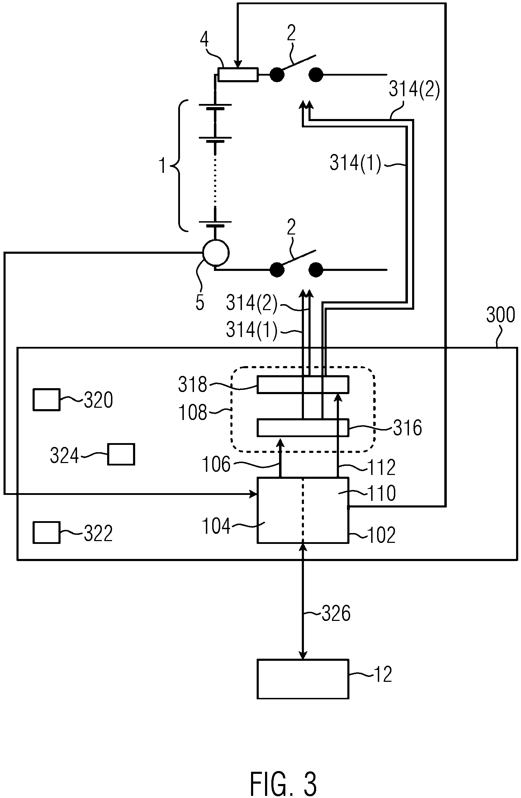

Fig. 3 shows a schematic block diagram of the second exemplary battery management system 300, which is an exemplary implementation of the first exemplary battery management system 100. The BMS 300 is configured to manage the operation of the battery 1, and in particular to control the opening and closing of the disconnection switch devices 2 and the activation of the overcurrent protection device 4. In particular, the BMS 300 has the same basic configuration as outlined for the BMS 100. Especially, the BMS 300 comprises the main control circuitry 102 having the main battery protection circuitry 104 and the auxiliary battery protection circuitry 110 and the switch device control circuitry 108 for controlling the disconnection switch devices 2 to be opened or closed, in order to regulate the power input or power output of the battery 1.

In the illustrated configuration, the main control circuitry 102 is formed as a single integrated circuit component, in particular with a common housing and a unifying substrate, for the main battery protection circuitry 104 and the auxiliary battery protection circuitry 110. Hereby, the main battery protection circuitry 104 and the auxiliary battery protection circuitry 110 may be designed as a single integrated circuit. However, in order to enhance the redundancy of the main control circuit 102 and to reduce the risk of common malfunction of the main battery protection circuitry 104 and of the auxiliary battery protection circuitry 110, the main control circuitry 102 is preferably designed as a multi-chip module. This can be realized, for example, by designing the main battery protection circuitry 104 and the auxiliary battery protection circuitry 110 as discrete integrated circuits, in particular arranged on discrete semiconductor chips, e.g. as discrete chiplets or in a dual die solution, as discrete system-on-chips. Hereby, each of the main battery protection circuitry 104 and the auxiliary battery protection circuitry 110 may be formed of a single integrated circuit or of more than one integrated circuit. Such a design has the advantage that the main battery protection circuitry 104 and the auxiliary battery protection circuitry 110 can be designed on separate substrate and accordingly can be easily adapted to application scenarios and needs. On the other side, the common housing of the two individual circuits allows to provide the main control circuitry 102 as an integrated circuit component, which can be easily integrated with the remaining components of the BMS 300.

In the illustrated configuration shown in Fig. 3, the switch device control circuitry 108 comprises at least two switch device drivers for opening and closing the disconnection switch devices 2, namely a first switch device driver 316 and a second switch device driver 318. In order to enhance the redundancy of the battery management system 300, the first switch device driver 316 and the second switch device driver 318 are advantageously provided on discrete integrated circuit components and do not share a common housing, so as to avoid that hardware faults in the first switch device driver 316 affect the second switch device driver 318 and vice versa. Furthermore, this implementation allows to enhance the scalability of the battery management system 300. In particular, each of the first switch device driver 316 and the second switch device driver 318 may be provided as a single integrated circuit or be built with two or more several discrete integrated circuits or discrete circuits housed in a common housing. Alternatively, it is however also possible, to house the first switch device driver 316 and the second switch device driver 318 in a common housing and provide a unifying substrate, so as to built the switch device control circuitry 108 as a single integrated circuit component, for example built by using chiplets, as a dual-die integrated circuit, or as a system-on-chips.

The first switch device driver 316 communicates with the main battery protection circuitry 104, for example by i2C, SPI, digitally or with another suitable communication interface known in the art, such as a PWM signal, to receive the first control instructions 106 generated by the main battery protection circuitry 104. In particular, the first switch device driver 316 only has a communication interface with the main battery protection circuitry 104, but not with the auxiliary battery protection circuitry 110, in order to avoid that a single point fault in the communication channel between the main battery protection circuitry 104 and the first switch device driver 316 affects the operation of the auxiliary battery protection circuitry 110 and of the second switch device driver 318. Advantageously, the first switch device driver 316 is able to detect a malfunction of the main battery protection circuitry 104, by monitoring the communication interface to the main battery protection circuitry 104. Especially, the first switch device driver 316 may have a configurable timeout function, and if the first switch device driver 316 does not receive a communication signal from the main battery protection circuitry 104 for a predetermined time ("self-disconnection time"), the first switch device driver 316 is configured to control the disconnection switch devices 2 to be opened, because in this case a malfunction and/or a stop of operation of the main battery protection circuitry 104 is assumed.

The second switch device driver 318 communicates with the auxiliary battery protection circuitry 110, for example by i2C, SPI, digitally or with another suitable communication interface known in the art, such as a PWM signal, to receive the second control instructions 112 generated by the auxiliary battery protection circuitry 110. In particular, the second switch device driver 318 only has a communication interface with the auxiliary battery protection circuitry 110, but not with the main battery protection circuitry 104, in order to avoid that a single point fault in the communication channel between the auxiliary battery protection circuitry 110 and the second switch device driver 318 affects the operation of the main battery protection circuitry 104 and of the first switch device driver 316. Advantageously, the second switch device driver 318 is able to detect a malfunction of the auxiliary battery protection circuitry 110, by monitoring the communication interface to the auxiliary battery protection circuitry 110. Especially, the second switch device driver 318 may also have a configurable timeout function, and if the second switch device driver 318 does not receive a communication signal from the auxiliary battery protection circuitry 110 for a predetermined time ("self-disconnection time"), the second switch device driver 318 is configured to control the disconnection switch devices 2 to be opened, because in this case a malfunction and/or a stop of operation of the auxiliary battery protection circuitry 110 is assumed.

The first switch device driver 316 controls the disconnection switch devices 2 to be open or closed in accordance with the received first control instructions 106, and the second switch device driver 318 controls the disconnection switch devices 2 to be open or closed in accordance with the received second control instructions 112 as indicated by arrows in Fig. 3. Hereby, the first switch device driver 316 and the second switch device driver 318 are designed in such a manner, that the disconnection switch devices 2 stay closed, as long as at least one of the first switch device driver 316 and the second switch device driver 318 controls the disconnection switch devices 2 to be closed. For this purpose, each of the first switch device driver 316 and the second switch device driver 318 may, for example, comprise a switch device power supply, which supplies power to the disconnection switch devices 2 in order to close the disconnection switch devices 2 (indicated by the arrows 314(1) and 314(2)). These switch device power supplies can then be connected with each other in series, so that the disconnection switch devices 2 remain supplied by one of the switch device power supplies and consequently remain closed, even after the power supply from the other switch device power supply has stopped, for example because a hardware fault in the main battery protection circuitry 104 or the auxiliary battery protection circuity 110 has occurred. Accordingly, only a stop of supplying power from both switch device power supplies controls the disconnection switch devices 2 to be open.

For example, the disconnection switch devices 2 may be contactors and each of the first switch device driver 316 and the second switch device driver 318 may supply a PWM modulated voltage to the contactor coils to close the contactors. Then, even when only one of the first switch device driver 316 and the second switch device driver 318 supplies the PWM modulated voltage, the contactor coils are still energized and the contactors remain closed. Accordingly, the contactors can remain closed especially in the case that a random hardware fault occurs in the main control circuitry 102, which affects only one of the main battery protection circuitry 104 and the auxiliary battery protection circuitry 110, so that a sudden power loss of power from the battery 1 is avoided for this case. In another example, the disconnection switch devices 2 may be power transistors or solid state switches and the first switch device driver 316 and the second switch device driver 318 may function as parallel voltage supplies that supply a defined voltage to the gates of the power transistor or to the solid state switches to achieve a similar effect.

In order to prevent that the first switch device driver 316 and the second switch device driver 318 erroneously close the disconnection switch devices 2 due to a hardware fault, the first switch device driver 316 is designed in such a manner that a single point fault in the first switch device driver 316 does not lead to a closing of the disconnection switch devices 2 and the second switch device driver 318 is designed in such a manner that a single point fault in the second switch device driver 318 does not lead to a closing of the disconnection switch devices 2. In particular, each of the first switch device driver 316 and the second switch device driver 318 preferably comprise redundant switches for controlling the opening and closing of the disconnection switch devices 2, so that even if one of these redundant switches is stuck in a close position ("stuck close error"), the disconnection switches 2 can still be opened.

To better protect the operation of the BMS 300 against failure of power supply, the BMS 300 comprises two separate and independently working power supplies, namely first power supply circuitry 320 and second power supply circuitry 322. Each of the first power supply circuitry 320 and the second power supply circuitry 322 includes suitable electronics, for example, a linear transistor, or a (DC-DC) voltage converter, for converting a voltage of at least one external power source to a voltage level, which is suitable for the electronic components of the BMS 300. Preferably, the first power supply circuitry 320 and the second power supply circuitry 322 are connected to different external voltage sources, so that a failure of one of the external voltage sources does not necessitate in stopping the operation of the BMS 300. For example, the first power supply circuitry 320 may be supplied with a low voltage, e.g. originating from an auxiliary battery or originating from mains, and the second power supply circuitry 322 may be supplied directly with the high voltage of the battery 1. Especially, when the BMS 300 is used in an electric vehicle, the first power supply circuitry 320 may be supplied from the auxiliary battery of the electric vehicle, e.g. at a low voltage level of 12 V, 24 V, 48 V or similar, and the second power supply circuitry 322 may be supplied from the high voltage driving battery, i.e. for example at high voltage levels in the range between 200 V to 800 V, or even larger.

In order to enhance the redundancy of the BMS 300, the main battery protection circuitry 104 and the first switch device driver 316 are powered by a different power supply than the auxiliary battery protection circuitry 110 and the second switch device driver 318, so that a malfunction of one of the first power supply circuitry 320 and of the second power supply circuitry 322 or of one of the external power supplies does not lead to a complete failure of the BMS 300. For example, the main battery protection circuitry 104 and the first switch device driver 316 are powered by the first power supply circuitry 320, while the auxiliary battery protection circuitry 110 and the second switch device driver 318 are powered by the second power supply circuitry 322 or vice versa.

In order to allow the main control circuitry 302 to determine the voltage of the battery 1 and of the individual battery cells of the battery 1, the BMS 300 comprises cell monitoring circuit 324, which is configured to measure the voltages and the temperatures of the battery cells of the battery 1. The cell monitoring circuitry 324 comprises one or measurement circuits for measuring a voltage and/or a temperature of the battery cells of the battery 1, e.g. one or more ADCs. In addition, the cell monitoring circuitry 324 comprises balancing circuits for balance the voltages of the battery cells of the battery 1. In a preferred implementation, the cell monitoring circuitry 324 is at least connected with the main battery protection circuitry 104 to allow the main battery protection circuitry 104 to determine the voltages and temperatures of the battery cell of the battery 1 and the voltages and temperature of the battery 1, as well as to balance the voltages of the battery cells. Alternatively, the cell monitoring circuitry 324 may be directly integrated into the main battery protection circuitry 104. Further, the cell monitoring circuitry 324 can also be connected to the auxiliary battery protection circuitry 110.

Preferably, the main battery protection circuitry 104 and the auxiliary battery protection circuitry 110 are configured to use an integration of the battery current for determining the state of charge of the battery 1, when the measurement signals from the cell monitoring circuitry 324 are not available, for example in case of a malfunction, like a hardware fault, of one of the measurement circuits of the cell monitoring circuit 324. This allows to avoid that a hardware fault in the cell monitoring circuitry 324 necessarily leads to stopping the operation of the BMS 300, because the determination of the state of charge of the battery 1 would not be possible with sufficient reliability. Furthermore, the integration of the battery current allows the main battery protection circuitry 104 and/or the auxiliary battery protection circuitry 110 to determine whether the battery 1 is charged or discharged even when the measurement signals from the cell monitoring circuitry 324 are not available. Accordingly, in the BMS 300 or the external controller 12 a control function can be implemented, which, in case of a malfunction of the cell monitoring circuit 324, allows to discharge the battery 1, but does not allow to charge the battery 1. In this way, an overcharging of the battery 1 can be avoided while a sudden power loss of the power supply by the battery 1 is prevented, so that, for example, it is still possible to drive an electric vehicle powered by the battery 1 for a limited amount of time.

As further shown in Fig. 3, the main control circuitry 102, comprises a communication interface 326, which enables the main control circuitry 102 to communicate with the external controller 12 (e.g. a vehicle ECU or a superordinate controller of a power grid), which supervises the operation of the BMS 300 and of the battery 1. The main control circuitry 102 can, for example, use a CAN (Controller Area Network) bus and a CAN protocol (like CAN, CANFD or CAN Extended), LIN (Local Interconnect Network), Flexray, an isoSPI (isolated Serial Port Interface) interface and the isoSPI protocol, or Ethernet for communicating with the external controller 12.

In a preferred exemplary implementation, the external controller comprises monitoring circuitry, which monitors the communication interface 326, in order to determine whether a malfunction of the main battery protection circuitry 104 is present. For example, the main control circuitry 102 may send every predetermined time interval, e.g. every 1 ms or every 10 ms, an electronic alive signal over the communication interface 326 to the monitoring circuitry, which indicates a proper operation of the main battery protection circuitry 104, so that in case of not receiving the electronic alive signal in an expected time window the monitoring circuitry may determine that the main battery protection circuitry 104 has a malfunction (e.g. due to a hardware fault). In case of detecting the presence of the malfunction in the main battery protection circuitry 104, the monitoring circuitry can then output a notification signal, which informs a user of the malfunction, for example by lighting a warning light in a vehicle. Alternatively or in addition, the monitoring circuitry may reduce the functionality of the battery 1, for example, by reducing the maximum output power of the battery, by limiting the operating range or operating time of the battery 1, by preventing another start of the battery 1 after the vehicle has been parked, i.e. the disconnection switches have been opened in a position where the vehicle is safe, or by allowing discharging of the battery 1, but disallowing charging of the battery 1. Of course, the monitoring circuit may also determine whether a malfunction of the auxiliary battery protection circuitry 110 is present. In an alternative implementation, the monitoring circuitry can be implemented as an internal component of the BMS 300, instead of being implemented in the external controller 12.

Turning now to Fig.4, an exemplary implementation of the main control circuitry 102 is described in more detail. In Fig. 4, the electronic circuits of the auxiliary battery protection circuitry 110 are arranged in the region indicated by the dashed line and the electronic circuits of the main battery protection circuitry 104 are arranged outside this dashed line. The main battery protection circuitry 104 comprises a (main) microcontroller 428, e.g. a lockstep microcontroller, which controls the operation of the main battery protection circuitry 104 by running dedicated software programs. The microcontroller 428 and the remaining electronic components are supplied by a first power supply unit 430 (indicated in Fig. 4 by arrows 431). The first power supply unit 430 comprises a first voltage converter, which converts the voltage input from the first power supply circuitry 320 (e.g. 12 V) to a suitable voltage level, like 3.3 V or 5 V. Further, the first power supply unit 430 comprises a watchdog timer that is configured to detect a malfunction of the microcontroller 428 and a malfunction of the first power supply unit 430 itself. In case that the watchdog timer detects a malfunction of the microcontroller 428 or of the first power supply unit 430, the watchdog timer generates a timeout signal 432, which causes the first switch device driver 316 to stop closing the disconnection switches 2. As an option, the timeout signal 432 may in addition indicate the malfunction of the microcontroller 428 to an auxiliary controller 434 of the auxiliary battery protection circuitry 110. In the shown example, the first power supply unit 430 also has a long duration timer, which allows for a configurable sleep and wake-up timer of the main battery protection circuitry 104 in order to save energy.

In order to instruct the switch device control circuitry 108 to open and close the disconnection switches 2, the main battery protection circuitry 104 comprises a first instruction signal generator circuit 435, which generates the first control instructions 106 on the basis of the state of the battery 1 determined by the microcontroller 428, and transmits the generated first control instructions 106 to the first switch device driver 316. For example, the first instruction signal generator circuit 435 is a PWM modulator, which generates a PWM signal, when it is determined by the microcontroller 428 that the disconnection switch devices 2 should be closed, and that does not generate a signal, when it is determined by the microcontroller 428 that the disconnection switch devices 2 should be opened, or vice versa.

For communicating with the internal components of the BMS 300 and with the external controller 12, the main battery protection circuitry 104 comprises the CANFD transceiver 436, the SPI transceiver 438, 440, 442 and the digital output 444. A first measuring circuit 446, preferably in form of an ADC, is provided for detecting the voltage across the current sensor 5, in order to measure the battery current. In addition, the first measuring circuit 446 can also measure various other parameters, such as a temperature, a humidity, a pressure, a gas concentration or a fluid level within the battery 1 or individual battery cells of the battery 1.

Should the BMS 300 be used in an electric vehicle, the first measuring circuit 446 is also connected to a first crash signal input 448, like a PWM modulated or steady signal, which indicates the occurrence of a crash to the main battery protection circuitry 104. In this case, it is advantegeous that the BMS 300 also comprises a first pyrofuse activation circuit 450, in order to be able to control the activation of at least one pyrofuse (or other overcurrent protection device) 4, which is connected in series with the battery 1, especially when the microcontroller 428 determines that the first crash signal input 448 indicates an accident (crash) of the electric vehicle or a rapid stop of the output power of the battery 1 is necessary due to a dangerous state of the battery 1.

In order to keep the battery 1 available even after a malfunction of the main battery protection circuitry 104, the auxiliary battery protection circuitry 110 comprises the auxiliary controller 434. The auxiliary controller 434 can be a second microcontroller, which redundantly performs all functions or only the most important functions of the microcontroller 428. Alternatively, the auxiliary controller 434 may be built from discrete logic circuits, to make the auxiliary battery protection circuitry 110 less complex. The auxiliary controller 434 and remaining electronic components of the auxiliary battery protection circuitry 110 are supplied by a second power supply unit 452 (indicated in Fig. 4 by arrows 453), so that the auxiliary battery protection circuitry 110 is supplied with voltage independently from the main battery protection circuitry 104. The second power supply unit 452 comprises a second voltage converter, which converts the voltage input from the second power supply circuitry 322 (e.g. 12 V) to a suitable voltage level, like 3.3 V or 5 V. Further, the second power supply unit 452 comprises a self-test circuit that is configured to detect a malfunction of the auxiliary controller 434 and a malfunction of the second power supply unit 452 itself, e.g. an over-voltage or an under-voltage of the output voltage level. In case that the self-test circuit detects a malfunction of the auxiliary controller 434 or of the second power supply unit 452, the self-test circuit generates a timeout signal 454, which indicates the malfunction of the auxiliary controller 434 and causes the second switch device driver 318 to stop closing the disconnection switch devices 2.

In addition, the auxiliary battery protection circuitry 110 comprises a boost converter 455, which can be connected to a capacitor to serve as an energy reservoir for the auxiliary controller 434 or for the energy needed to activate (ignite) the pyro squib in the pyrofuse (or other overcurrent protection device) 4.

In order to instruct the switch device control circuitry 108 to open and close the disconnection switches 2, after the main battery protection circuitry 104 has stopped operation, the auxiliary battery protection circuitry 110 comprises a second instruction signal generator circuit 456, which generates the second control instructions 112 in analogy to the first instruction signal generator circuit 435, but on the basis of the state of the battery 1 determined by the auxiliary controller 434. The generated first control instructions 106 are transmitted to the second switch device driver 318. The state of the battery 1 is determined by the auxiliary controller 434 independently from the main battery protection circuitry 104 by using the input of a second measuring circuit 458 arranged separately from the first measuring circuit 446. The second measuring circuit 458, which preferably is an ADC, at least detects a voltage across the current sensor 5' (or the current sensor 5) in order to measure the battery current. To simplify the auxiliary battery protection circuitry 110, the second measuring circuit 458 may have a lower accuracy or may use less inputs to measure less parameters than the first measuring circuit 446, but the second measuring circuit 458 may also be configured with the same accuracy and inputs as the first measuring circuit 446.

Should the BMS 300 be used in an electric vehicle, the second measuring circuit 458 is also connected to a second crash signal input 460, like a PWM modulated or steady signal, which indicates the occurrence of a crash to the auxiliary battery protection circuitry 110. In this case, it is preferable that the auxiliary battery protection circuitry 110 also comprises a second pyrofuse activation circuit 462, in order to be able to control the activation of at least one pyrofuse (or other overcurrent protection device) 4 in emergency cases like a crash indicated by the second crash signal input 460, even after the main battery protection circuitry 104 has stopped operation, e.g. due to a malfunction.

In this manner, the auxiliary battery protection circuitry 110 can provide at least the basic functions of the main battery protection circuitry 104 redundantly, so that the auxiliary battery protection circuitry 110 can determine the state of the battery 1 and can, in accordance with the determined state of the battery 1, control the switch device control circuitry 108 in accordance with the determined state of the battery 1 to open and close the disconnection switch devices 2 or activate the overcurrent protection device 4 even after a malfunction in the main battery protection circuitry 104 has occurred. Accordingly, by using the BMS 300, it is not necessary to open the disconnection switch devices 2 as soon as the malfunction in the main battery protection circuitry 104 occurs, so that a sudden power loss of the battery can be prevented. Since the auxiliary battery protection circuitry 110 can be designed to determine the state of the battery 1 with less accuracy and may be designed to have lower functionality in order to reduce the complexity of the BMS 300, it is though possible that the auxiliary battery protection circuitry 110 may be configured with a timer, which stops the operation of the auxiliary battery protection circuitry 110 after a predetermined time, which allows a user to bring the battery 1 or an electric vehicle powered by the battery 1 to a safe state/place.

It is understandable for the skilled person that the above mentioned numbers of circuit components are only used for illustration purposes and are not meant to be limiting. Furthermore, more than the battery management system 100 may comprise more than one auxiliary battery protection circuitry 110 and more than two switch device drivers in order to enhance the redundancy and flexibility of the battery management system 100.

**REFERENCE NUMERALS**

| | |
|---|---|
| 1 | battery |
| 2 | (disconnection) switch device |
| 4 | overcurrent protection device |
| 5, 5' | current sensor |
| 100, 300 | Battery management system |
| 102 | main control circuitry |
| 104 | main battery protection circuity |
| 106 | first control instructions |
| 108 | switch device control circuitry |
| 110 | auxiliary battery protection circuitry |
| 112 | second control instructions |
| 316 | first switch device driver |
| 318 | second switch device driver |
| 320, 322 | power supply circuitry |
| 324 | cell monitoring circuitry |
| 326 | communication interface |
| 428 | (main) microcontroller |
| 430 | first power supply unit |
| 432, 454 | timeout signals |
| 434 | auxiliary controller |
| 435 | first instruction signal generator circuit |
| 436, 438, 440, 442, 444 | Communication circuits |
| 446 | first measuring circuit |
| 448, 460 | crash signal inputs |
| 450 | first pyrofuse activation circuit |
| 452 | second power supply unit |
| 455 | boost converter |
| 456 | second instruction signal generator circuit |
| 458 | second measuring circuit |
| 462 | second pyrofuse activation circuit |

## Claims

1. A battery management system (100, 300) comprising:
a main battery protection circuitry (104), which is configured to determine a state of a battery (1) as a first determined state, and to generate first control instructions (106) indicating to open or to close at least one switch device (2), which is connected in series with the battery (1), in accordance with the first determined state;
an auxiliary battery protection circuitry (110), separate from the main battery protection circuitry (104), configured to determine the state of the battery (1) as a second determined state, and to generate second control instructions (112) indicating to open or to close the at least one switch device (2) in accordance with the second determined state; and
a switch device control circuitry (108), which is configured to receive the first control instructions (106) from the main battery protection circuitry (104) and the second control instructions (112) from the auxiliary battery protection circuitry (110), and control the at least one switch device (2) to be opened or to be closed in accordance with the received control instructions,
wherein the switch device control circuitry (108) is configured to control the at least one switch device (2) to be closed, when at least one of the first control instructions (106) and of the second control instructions (112) indicate to close the at least one switch device (2).

2. The battery management system (100, 300) according to claim 1, wherein, when a malfunction of the main battery protection circuitry (104) is detected, the main battery protection circuitry (104) is configured to stop operation and to indicate to the switch device control circuitry (108) to open the at least one switch device (2); and/or
when a malfunction of the auxiliary battery protection circuitry (110) is detected, the auxiliary battery protection circuitry (110) is configured to stop operation and to indicate to the switch device control circuitry (108) to open the at least one switch device.

3. The battery management system (100, 300) according to claim 2, wherein the auxiliary battery protection circuitry (110) only performs the determination of the second determined state and the generation of the second control information (112) after the main battery protection circuit (104) has stopped operation.

4. The battery management system (100, 300) according to one of the preceding claims, wherein the main battery protection circuitry (104) comprises a first voltage converter (430), which is configured to supply the electric components of the main battery protection circuit (104), and wherein the auxiliary battery protection circuitry (110) comprises a second voltage converter (452), which is arranged independently from the first voltage converter (430) and is configured to supply the electric components of the auxiliary battery protection circuit (110), and wherein the first voltage converter (430) and the second voltage converter (452) are respectively supplied by individual voltage sources.

5. The battery management system (100, 300) according to one of the preceding claims, wherein the main battery protection circuitry (104) comprises a first measuring circuit (446) for measuring a battery current of the battery (1), and wherein the auxiliary battery protection circuitry (110) comprises a second measuring circuit (458) for measuring the battery current of the battery (1).

6. The battery management system (100, 300) according to claim 5, wherein the main battery protection circuitry (104) determines a state of charge of the battery (1) by integrating the battery current, when a voltage measurement of the voltage of the battery (1) is not available for the main battery protection circuitry (104), and/or
wherein the auxiliary battery protection circuitry (110) determines the state of charge of the battery (1) by integrating the battery current, when a voltage measurement of the voltage of the battery (1) is not available for the auxiliary battery protection circuitry (110).

7. The battery management system (100, 300) according to one of the preceding claims, wherein the main battery protection circuitry (104) is further configured to control activation of at least one overcurrent protection device (4), which is connected in series with the battery (1), in accordance with the state of the battery (1) determined by the main battery protection circuitry (104) and/or in accordance with an external control signal, and
wherein the auxiliary battery protection circuitry (110) is further configured to redundantly control activation of the at least one overcurrent protection device (4) in accordance with the state of the battery (1) determined by the auxiliary battery protection circuitry (110) and/or in accordance with the external control signal.

8. The battery management system (100, 300) according to one of the preceding claims, wherein the main battery protection circuitry (104) and the auxiliary battery protection circuitry (110) are provided on discrete semiconductor chips.

9. The battery management system (100, 300) according to one of the preceding claims, wherein the main battery protection circuitry (104) and the auxiliary battery protection circuitry (110) are housed in a common housing to form a single integrated circuit component.

10. The battery management system (100, 300) according to one of the preceding claims, wherein the switch device control circuitry (108) comprises
a first switch device driver (316), which is configured to open and close the at least one switch device (2) in accordance with the first control instructions (106), and
a second switch device driver (318), which is configured to open and close the at least one switch device (2) in accordance with the second control instructions (112),
wherein the first switch device driver (316) and the second switch device driver (318) are configured in such a manner that the at least one switch device (2) is closed, when at least one of the first switch device driver (316) and the second switch device driver (318) closes the at least one switch device (2).

11. The battery management system (100, 300) according to claim 10, wherein the first switch device driver (318) and the second switch device driver (320) are mounted on different discrete integrated circuit components.

12. The battery management system according to one of claims 10 or 11, wherein
the first switch device driver (318) is configured to open the at least one switch device (2), when the first switch device driver (318) does not receive a communication signal from the main battery protection circuitry (104) for a first predetermined time; and/or
the second switch device driver (320) is configured to open the at least one switch device, when the second switch device driver (320) does not receive a communication signal from the auxiliary battery protection circuitry (110) for a second predetermined time.

13. A battery protection system, which comprises:
the battery management system (100, 300) according to one of claims 1 to 12, and
monitoring circuitry, which is configured to
• detect presence or absence of a malfunction of the main battery protection circuitry (104), and
• when a malfunction of the main battery protection circuitry (104) is detected, output a first notification signal and/or cause the battery (1) to be used with reduced functionality.

14. A battery pack, which comprises:
a battery (1), and
the battery management system (100, 300) according to one of claims 1 to 12 or the battery protection system according to claim 13.

15. A switch device control method comprising the steps of:
receiving first control instructions (106) indicating to open or to close at least one switch device (2), which is connected in series with a battery (1), wherein the first control instructions (106) are generated by a main battery protection circuit (104) in accordance with a first determined state of the battery (1);
receiving second control instructions (112) indicating to open or to close the at least one switch device (2), wherein the second control instructions (112) are generated by an auxiliary battery protection circuitry (110), separate from the main battery protection circuitry (104), in accordance with a second determined state of the battery (1);
opening and closing the at least one switch device (2) in accordance with the received first control instructions (106) and the received second control instructions (112),
wherein the at least one switch device is closed, when at least one of the first control instructions (106) and of the second control instructions (112) indicate to close the at least one switch device.
